# EUROPEAN PATENT APPLICATION

(11) **EP 4 407 875 A1**
(43) Date of publication of application: **31.07.2024**
(21) Application number: 24153826.3
(22) Date of filing: 25.01.2024
(51) Int. Cl.: H03M 3/00

(54) **ANALOG-DIGITAL HYBRID INTEGRATOR CIRCUIT**

(30) Priority: 25.01.2023 KR 20230009598
(71) Applicant: Korea Advanced Institute of Science and Technology, Daejeon 34141 (KR)
(72) Inventor: JUNG, Wanyeong, Daejeon 34141 (KR); YANG, Minkyu, Daejeon 34141 (KR)
(74) Representative: Eisenführ Speiser

(57) **Abstract**

The present disclosure provides an analog-digital hybrid integrator circuit which includes an operational amplifier coupled to an input terminal, a first capacitor coupled to the input terminal in parallel with the operational amplifier, a plurality of second capacitors coupled in parallel with the first capacitor, and a plurality of buffers that is coupled in series and is coupled in parallel with the plurality of second capacitors, respectively.

## Description

### CROSS-REFERENCE TO RELATED APPLICATIONS

This application claims benefit and priority to Korean Patent Application No. 10-2023-0009598, filed on January 25, 2023, with the Korean Intellectual Property Office, the disclosure of which is incorporated herein in its entirety by reference.

### TECHNICAL FIELD

The present disclosure relates to an analog-digital hybrid integrator circuit.

### BACKGROUND

Integrators are key mixed-signal circuit building blocks, and are mainly used in analog-to-digital converters, delta-sigma modulators, and the like. In addition, switched-capacitor integrators are circuits for periodically charging input capacitors and integrating the charge in integrating capacitors.

Active integrators according to the related art may be applied to various ADCs for shaping noise, and may consume a lot of power for high performance, thereby obtaining high gains.

Active integrators may be classified into analog integrators, digital integrators, and analog-digital hybrid integrators.

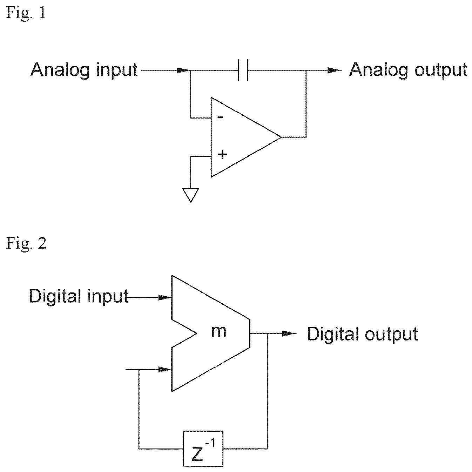

FIG. 1 is a circuit diagram illustrating an analog integrator according to the related art.

Referring to FIG. 1, an analog input signal Vin is integrated by an analog operational amplifier 1 and is stored in a capacitor 2. Charge stored in the capacitor 2 causes an analog output signal Vout. In this case, the analog operational amplifier 1 consumes high static power.

FIG. 2 is a circuit diagram illustrating a digital integrator according to the related art.

Referring to FIG. 2, a digital input signal Vin is integrated by a digital operational amplifier 3, and then is fed back through a unit cycle delay (z⁻¹) 4. In this case, the digital integrator produces an output signal with a quantization error because it integrates a quantized signal.

Digital integrators show limitations in storable accuracy. For example, when a digital integrator with an accuracy of 0.01 to store a number X, i.e., 0.3218231..., 0.322 is stored and the difference obtained by subtracting 0.3218231... from 0.322, i.e., the value of 0.000177... remains as an error, and as the number of times of integration increases, the digital integrator produces a further amplified error.

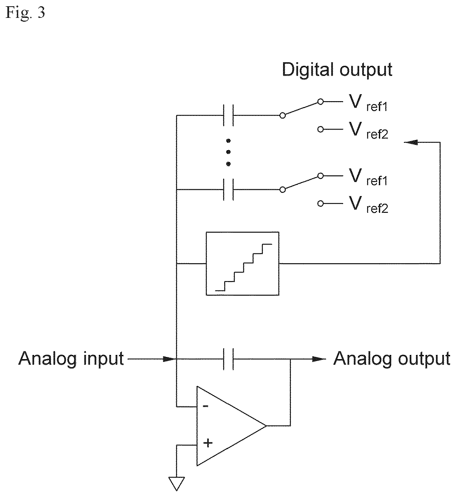

FIG. 3 is a circuit diagram illustrating a hybrid integrator according to the related art.

Referring to FIG. 3, after an analog input signal Vin is converted into a digital signal by a quantizer 5, and the digital signal is fed back and is integrated by a capacitor 2, an analog operational amplifier 1 generates an analog output signal. The hybrid integrator stores the digital signal obtained by converting the analog input signal, and also stores the analog output signal. The hybrid integrator according to the related art cannot perform continuous integration, and causes a time delay because integration is possible after quantization of an analog input signal.

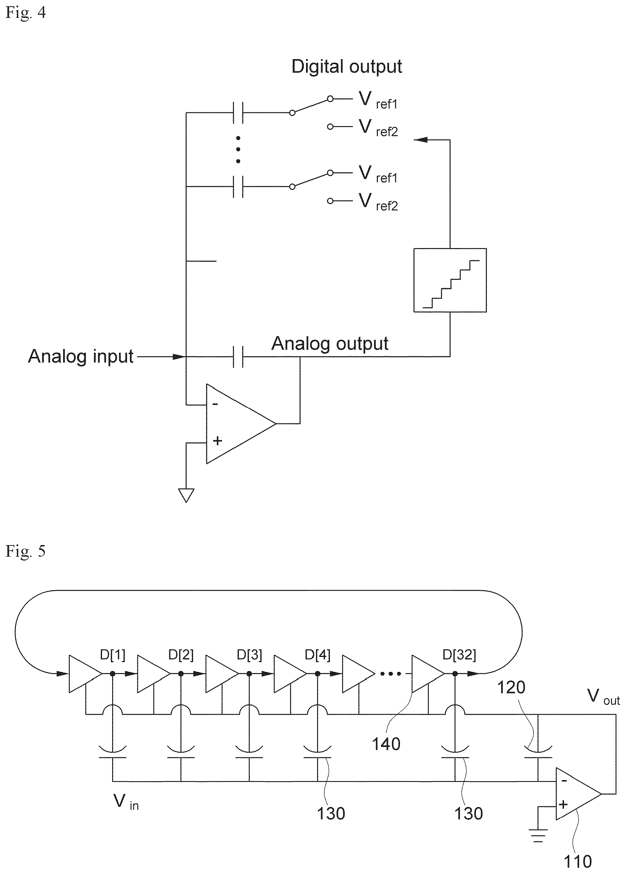

FIG. 4 is a circuit diagram illustrating another hybrid integrator according to the related art.

Referring to FIG. 4, an analog input signal Vin is integrated by a capacitor 2 and then is converted into a digital signals by a quantizer 5. The digital signal is fed back to an analog operational amplifier 1. The hybrid integrator stores the digital signals obtained by converting the analog input signal and also stores an analog output signal. The hybrid integrators according to the related art exhibit increased nonlinearity due to the mismatches between the quantizers and the feedback capacitors, and cause a time delay of one clock because integration is possible after quantization of an analog input signal.

### SUMMARY

In order to solve the above-mentioned problems, the present disclosure has been made in an effort to provide a hybrid integrator that simultaneously performs integration of an input signal and digital conversion on the input signal.

The present disclosure has been made in an effort to provide a hybrid integrator that stores all of digital quantized signals and analog residual signals, thereby enabling continuous integration.

The present disclosure has been made in an effort to provide a hybrid integrator that eliminates a mismatch between a digital quantized signal and a feedback capacitor and minimizes the time delay between quantization of an input signal and an integration operation.

Objects of the present disclosure are not limited to the above-mentioned objects, and other objects that have not been mentioned will be apparently understood from the following description. Technical challenges of the present disclosure are not limited to the above-mentioned technical challenges, and other challenges that have not been mentioned will be apparently understood from the following description by those skilled in the art.

An exemplary embodiment of the present disclosure provides a hybrid integrator which includes an operational amplifier coupled to an input terminal, a first capacitor coupled to the input terminal in parallel with the operational amplifier, a plurality of second capacitors coupled in parallel with the first capacitor, and a plurality of buffers that is coupled in series and is coupled in parallel with the plurality of second capacitors, respectively.

The operational amplifier provides an output voltage to each of the plurality of buffers.

The plurality of buffers is coupled in series so as to form a delay chain.

The buffers include first buffers that receive '1' and output '1', second buffers that receive '0' and output '0', third buffers that receive a state of '0' and output a state of '1', thereby forming rising edges and fourth buffers that receive the state of '1' and output the state of'0', thereby forming falling edges.

In an initial state, the number of first buffers is the same as the number of second buffers.

When an output voltage fed from the operational amplifier back to the buffers is greater than an existing voltage, the fourth buffers output '1', thereby changing to first buffers, whereby the number of first buffers increases and the fourth buffers that form falling edges are propagated and migrated toward the second buffers.

When an output voltage fed from the operational amplifier back to the buffers is smaller than an existing voltage, the third buffers output '0', thereby changing to second buffers, whereby the number of second buffers increases and the third buffers that form rising edges are propagated and migrated toward the first buffers.

Another exemplary embodiment of the present disclosure provides a hybrid integrator that includes an operational amplifier that receives a difference signal obtained by subtracting a quantized output signal from an input signal and integrates the difference signal, a first capacitor that stores a residual signal, a plurality of buffers that quantize an output signal of the operational amplifier and is coupled in series, a plurality of second capacitors that store the input signal and the quantized output signal of the buffers, first switches that are coupled between an input terminal and the plurality of second capacitors and between the plurality of second capacitors and a ground terminal, and are switched so as to output the input signal of the input terminal to the plurality of second capacitors, and second switches that are coupled between the output terminals of the plurality of buffers and the plurality of second capacitors and between the plurality of second capacitors and the operational amplifier and are switched so as to output the difference signal to the operational amplifier.

The hybrid integrator according to another exemplary embodiment of the present disclosure further includes a first reset switch that is coupled in parallel with the first capacitor and the operational amplifier and resets the residual signal of the first capacitor.

The hybrid integrator according to another exemplary embodiment of the present disclosure further includes a second reset switch that is coupled to the output terminals of the plurality of buffers and receives a reference voltage Vref, thereby resetting the plurality of buffers and the plurality of second capacitors to their initial states when the second reset switch is on.

When the first switches are switched on and the second switches are switched off, the input signal of the input terminal is stored in the plurality of second capacitors.

When the first switches are switched off and the second switches are switched on, the plurality of buffers outputs a quantized output signal to the plurality of second capacitors, and the plurality of second capacitors outputs a difference signal obtained by subtracting the quantized output signal of the plurality of buffers from the stored analog input signal, to the operational amplifier.

According to the exemplary embodiments of the present disclosure, the hybrid integrators can be driven mostly by capacitors in a digital domain, whereby it is possible to reduce the capacitor size in an analog domain, thereby significantly reducing the power consumption of the operational amplifiers.

According to the exemplary embodiments of the present disclosure, the hybrid integrators can secure energy efficiency and structural simplification because they do not require additional quantizers.

According to the exemplary embodiments of the present disclosure, the hybrid integrators can achieve high speed because separate integration and quantization are simultaneously performed by a buffer chain coupled in a circle.

According to the exemplary embodiments of the present disclosure, the hybrid integrators have high linearity without a separate circuit and exhibit a mismatch shaping effect of the capacitors because edges are continuously propagated by consecutive operations due to the circular structures of the delay chains.

Effects of the present disclosure are not limited to the above-mentioned effects, and other effects that have not been mentioned will be apparently understood from the following description by those skilled in the art.

The foregoing summary is illustrative only and is not intended to be in any way limiting. In addition to the illustrative aspects, embodiments, and features described above, further aspects, embodiments, and features will become apparent by reference to the drawings and the following detailed description.

### BRIEF DESCRIPTION OF THE DRAWINGS

FIG. 1 is a circuit diagram illustrating an analog integrator according to the related art.
FIG. 2 is a circuit diagram illustrating a digital integrator according to the related art.
FIG. 3 is a circuit diagram illustrating a hybrid integrator according to the related art.
FIG. 4 is a circuit diagram illustrating another hybrid integrator according to the related art.
FIG. 5 is a circuit diagram illustrating a hybrid integrator according to an exemplary embodiment of the present disclosure.
FIG. 6 is a circuit diagram illustrating a delay chain of the hybrid integrator according to the exemplary embodiment of the present disclosure.
FIG. 7 is a circuit diagram illustrating a feedback operation of the hybrid integrator according to the exemplary embodiment of the present disclosure.
FIG. 8 is a circuit diagram illustrating a hybrid integrator according to another exemplary embodiment of the present disclosure.
FIG. 9 is a diagram illustrating an operating state of the hybrid integrator according to another exemplary embodiment of the present disclosure by a φ1 signal.
FIG. 10 is a diagram illustrating an operating state of the hybrid integrator according to another exemplary embodiment of the present disclosure by a φ2 signal.
FIG. 11A is a timing chart illustrating a reset clock that resets a first capacitor.
FIG. 11B is a timing chart illustrating a clock signal that controls ON-OFF operations of first switches and second switches.
FIG. 11C is a timing chart illustrating an output signal of an operational amplifier that is fed back.
FIG. 11D is a timing chart illustrating quantized output signals of buffers.
FIG. 11E is a timing chart illustrating an input signal and a final output subjected to digital signal processing, of the hybrid integrator according to another exemplary embodiment of the present disclosure.

### DETAILED DESCRIPTION

In the following detailed description, reference is made to the accompanying drawing, which forms a part hereof. The illustrative embodiments described in the detailed description, drawing, and claims are not meant to be limiting. Other embodiments may be utilized, and other changes may be made, without departing from the spirit or scope of the subject matter presented here.

While the present disclosure may be modified in various ways and take on various alternative forms, specific exemplary embodiments thereof will be described in detail with reference to the drawings. However, this is not intended to limit the present disclosure to the specific exemplary embodiments, and it will be appreciated that the present disclosure includes all of the modifications, equivalent matters, and substitutes included in the spirit and technical scope of the present disclosure. When the individual drawings are described, similar constituent elements are denoted by similar reference symbols.

Terms such as first, second, A, and B are used for describing various constituent elements, but the constituent elements are not limited by the terms. The terms are used only to discriminate one constituent element from another constituent element. For example, a first element may be termed a second element, and similarly, a second element may be termed a first element, without departing from the scope of the present disclosure. A term 'and/or" includes a combination of a plurality of associated disclosed items or any item of the plurality of associated disclosed items.

When a constituent element is referred to as being "connected" or "coupled" to another constituent element, it will be appreciated that it may be directly connected or coupled to the other constituent element or intervening other constituent elements may be present. In contrast, when a constituent element is referred to as being "directly connected" or "directly coupled" to another constituent element, it will be appreciated that there are no intervening other constituent elements present.

The terms used in this specification are merely for the purpose of describing specific exemplary embodiments, and are not intended to limit the present disclosure. Singular forms include plural forms as well unless the context clearly indicates otherwise. In the present application, it will be appreciated that terms "including" and "having" are intended to designate the existence of characteristics, numbers, steps, operations, constituent elements, and components described in the specification or a combination thereof, and do not exclude a possibility of the existence or addition of one or more other characteristics, numbers, steps, operations, constituent elements, and components, or a combination thereof in advance.

It should also be understood that the terms "first" and "second" are used in this specification for distinguishing purposes only, and are not meant to indicate or anticipate sequence or priority in any way.

Unless defined otherwise, all terms used herein, including technical and scientific terms, have the same meaning as commonly understood by one of ordinary skill in the art to which the present disclosure belongs. Terms such as those defined in commonly used dictionaries should be interpreted as having a meaning consistent with the meaning in the context of the related art, and should not be interpreted in an ideal or excessively formal meaning unless explicitly defined in the present application.

Throughout the specification and claims, when a part includes a certain element, it means that other elements may be further included, rather than excluding other elements, unless specifically stated to the contrary.

Hereinafter, preferred embodiments according to the present disclosure will be described in detail with reference to the drawings.

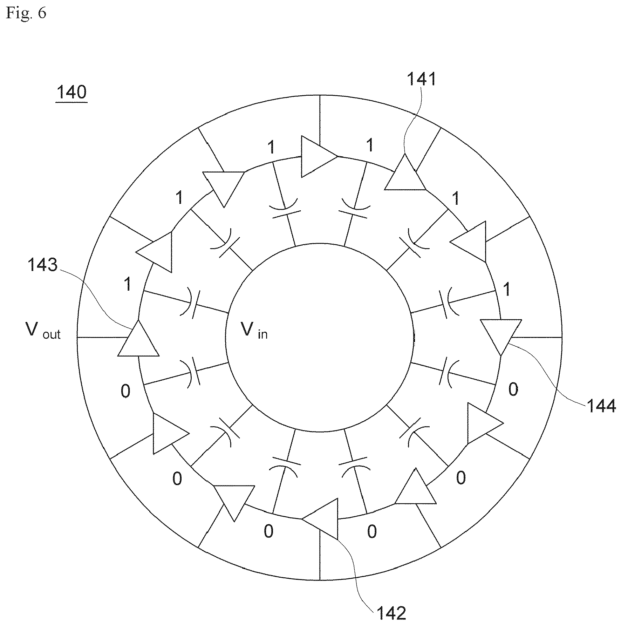

FIG. 5 is a circuit diagram illustrating a hybrid integrator according to an exemplary embodiment of the present disclosure. FIG. 6 is a circuit diagram illustrating a delay chain of the hybrid integrator according to the exemplary embodiment of the present disclosure.

Referring to FIG. 5, a hybrid integrator according to an exemplary embodiment of the present disclosure includes an operational amplifier 110 coupled to an input terminal, a first capacitor 120 coupled to the input terminal in parallel with the operational amplifier 110, a plurality of second capacitors 130 coupled in parallel with the first capacitor 120, and a plurality of buffers 140 that is coupled in series and is coupled in parallel with the plurality of second capacitors 130, respectively.

The operational amplifier 110 integrates an analog input signal in an analog domain. The operational amplifier 110 generates an output voltage for controlling the second capacitors 130 and the buffers 140 constituting a delay chain and provides the output voltage to each buffer 140.

The first capacitor 120 forms an analog domain together with the operational amplifier 110 so as to store an analog signal integrated by the operational amplifier 110.

Referring to FIGS. 5 and 6, the second capacitors 130 are coupled in parallel with the first capacitor 120 and form a digital domain together with the buffers 140, and receive the output of the operational amplifier 110 as a control signal, thereby operating. The number of second capacitors 130 may be the same as the number of buffers 140.

Referring to FIGS. 5 and 6, the number of buffers 140 may be an even number, and may be 2ⁿ such that the buffers can serve as a n-bit quantizer. For example, the number of buffers 140 is 2⁵, i.e., 32 such that the buffers can serve as a 5-bit quantizer.

Alternatively, the number of buffers 140 may be an odd number, and may be 2ⁿ-1 such that the buffers can serve as a n-bit quantizer. For example, the number of buffers 140 is 2⁵-1, i.e., 31 such that the buffers can serve as a 5-bit quantizer.

The buffers 140 are coupled in series and are driven as a circular delay chain. Each of the buffers 140 is coupled to the output terminal of the operational amplifier 110 and receives the output voltage of the operational amplifier 110.

The buffers 140 are disposed between the output terminals of the second capacitors 130, respectively, and are coupled in series. Accordingly, the buffers 140 are coupled in parallel with the second capacitors 130 and are coupled in parallel with the first capacitor 120.

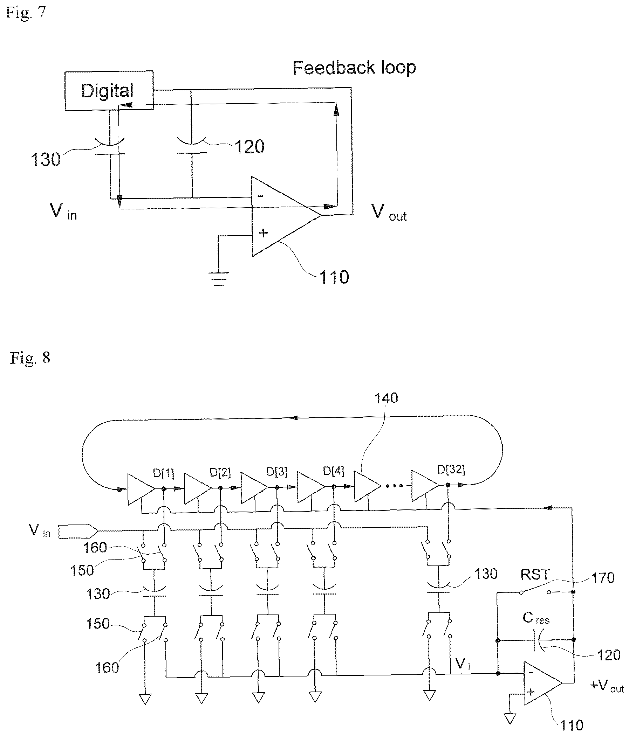

The operation of the hybrid integrator according to the exemplary embodiment of the present disclosure is as follows. FIG. 7 is a circuit diagram illustrating a feedback operation of the hybrid integrator according to the exemplary embodiment of the present disclosure.

Referring to FIG. 7, in the hybrid integrator, the voltage output from the operational amplifier 110 is varied by an analog input signal. The varied output voltage is input to the buffers 140 that are driven as a circular delay chain, whereby a feedback loop is formed.

In an initial state, the buffers 140 include first buffers 141 that receive '1' and output '1', and second buffers 142 that receive '0' and output '0'. In the initial state, the number of first buffers 141 may be the same as the number of second buffers 142.

The buffers 140 include third buffers 143 that receive the state of '0' and output the state of '1', thereby forming rising edges and fourth buffers 144 that receive the state of '1' and output the state of '0', thereby forming falling edges.

For example, when the number of buffers 140 is 32 in order to represent 5 bits, the number of first buffers 141 is 15, and the number of second buffers 142 is 15, and the third buffers 143 are disposed between the first buffers 141 and the second buffers 142, respectively, and the fourth buffers 144 are disposed between the first buffers 141 and the second buffers 142, respectively.

When the output voltage fed from the operational amplifier 110 back to the buffers 140 is greater than the existing voltage, the fourth buffers 144 change to first buffers 141 that receive the state of '1' and output '1', and the second buffers 142 coupled to the fourth buffers 144 change to first buffers 141 through fourth buffers 144 up to the magnitude of the feedback output voltage.

In other words, when the feedback output voltage is greater than the existing voltage, the fourth buffers 144 of the falling edges output '1', thereby changing first buffers 141. As a result, the number of first buffers 141 increases and fourth buffers 144 that form falling edges are propagated and migrated toward the second buffers 142.

Meanwhile, when the output voltage fed from the operational amplifier 110 back to the buffers 140 is smaller than the existing voltage, the third buffers 143 change to second buffers 142 that receive the state of '0' and output '0', and the first buffers 141 coupled to the third buffers 143 change to second buffers 142 through third buffers 143 up to the magnitude of the feedback output voltage.

In other words, when the feedback output voltage is smaller than the existing voltage, the third buffers 143 of the rising edges output '0', thereby changing second buffers 142. As a result, the number of second buffers 142 increases and third buffers 143 that form rising edges are propagated and migrated toward the first buffers 141.

The second capacitors 130 sample the outputs of the buffers 140 in the changed states, and store them.

When this operation is completed, the second capacitors 130 output a part of the input voltage as a quantized digital signal, and the analog operational amplifier 1 outputs the rest of the input voltage as an analog residual signal.

For example, the case where, when the number of buffers 140 is 32 in order to represent 5 bits, and in the initial state, the number of first buffers 141 is 15, and the number of second buffers 142 is 15, and the third buffers 143 are disposed between the first buffers 141 and the second buffers 142, respectively, and the fourth buffers 144 are disposed between the first buffers 141 and the second buffers 142, respectively, will be described.

When the input voltage is +10.4, the number of first buffers 141 that output '1' among the buffers 140 is increased to 25 by 10, and the second capacitors 130 coupled to the increased first buffers 141 sample the increase in the number of first buffers, i.e., 10 and each store '1'. Thereafter, when the second capacitors 130 output a quantized digital signal of'10' and the operational amplifier 110 outputs 0.4 as the residual signal of the input voltage, the first capacitor 120 stores the analog output signal, i.e., 0.4.

In this state, if an input signal of +3.92 is additional input, in order for the hybrid integrator of the present disclosure to express a total of +14.32, four of the buffers 140 in the state of '0' additionally change to first buffers 141, and fourth buffers 144 are propagated until the total number of first buffers 141 becomes 19. Accordingly, the second capacitors 130 coupled to the increased first buffers 141 sample 4 which is the increase in the number of first buffers 141, and each store '1'. Thereafter, when the second capacitors 130 output a quantized digital signal of '14' and the operational amplifier 110 outputs 0.32 as the residual signal of the input voltage, the first capacitor 120 stores the analog output signal, i.e., 0.32.

Accordingly, the hybrid integrator according to the exemplary embodiment of the present disclosure can continuously integrate input signals without resetting.

A hybrid integrator according to another exemplary embodiment of the present disclosure will be described as follows. FIG. 8 is a circuit diagram illustrating a hybrid integrator according to another exemplary embodiment of the present disclosure.

Referring to FIG. 8, a hybrid integrator according to another exemplary embodiment of the present disclosure includes: an operational amplifier 110 that receives a difference signal obtained by subtracting a quantized output signal from an input signal and integrates the difference signal; a first capacitor 120 that stores a residual signal; a plurality of buffers 140 that quantize an output signal of the operational amplifier 110 and is coupled in series; a plurality of second capacitors 130 that stores the input signal and the quantized output signal of the plurality of buffers; first switches 150 that are coupled between an input terminal and the plurality of second capacitors 130 and between the plurality of second capacitors 130 and a ground terminal and are switched so as to output the input signal of the input terminal to the plurality of second capacitors 130; and second switches 160 that are coupled between the output terminals of the plurality of buffers 140 and the plurality of second capacitors 130 and between the plurality of second capacitors 130 and the operationalamplifier 110, and are switched so as to output the difference signal to the operational amplifier 110.

Referring to FIG. 8, the hybrid integrator according to another exemplary embodiment of the present disclosure may further include a first reset switch 170 that is coupled in parallel with the first capacitor 120 and the operational amplifier 110 and resets the residual signal of the first capacitor 120.

The hybrid integrator according to another exemplary embodiment of the present disclosure may further include a second reset switch (not shown in the drawings) that is coupled to the output terminals of the plurality of buffers 140, and receives a reference voltage Vref in an ON state, thereby resetting the plurality of buffers 140 and the plurality of second capacitors 130 to their initial states.

The operational amplifier 110 integrates an analog input signal in an analog domain. The operational amplifier 110 generates an output signal for controlling the second capacitors 130 and the buffers 140 constituting a delay chain and provides the output signal to each buffer 140.

The first capacitor 120 forms an analog domain together with the operational amplifier 110 so as to store an analog signal integrated by the operational amplifier 110.

The number of buffers 140 may be an even number, and may be 2⁵, i.e., 32 such that the buffers can serve as a 5-bit quantizer. The buffers 140 are coupled in series and are driven as a circular delay chain.

Alternatively, the number of buffers 140 may be an odd number, and may be 2ⁿ-1 such that the buffers can serve as a n-bit quantizer. For example, the number of buffers 140 is 2⁵-1, i.e., 31 such that the buffers can serve as a 5-bit quantizer.

Further, the buffers 140 are disposed between the output terminals of the second capacitors 130, respectively, and are coupled in series. The buffers 140 are coupled in parallel with the second capacitors 130 and are coupled in parallel with the first capacitor 120.

The buffers 140 are coupled in series and are driven as a circular delay chain. Each of the buffers 140 is coupled to the output terminal of the operational amplifier 110 and receives the output voltage of the operational amplifier 110.

The second capacitors 130 are coupled in parallel with the first capacitor 120, and receive the output of the operational amplifier 110 as a control signal, thereby operating, together with the buffers 140. The number of second capacitors 130 may be the same as the number of buffers 140.

The second capacitors 130 store the input signal of the input terminal by the ON operations of the first switches 150, and output a difference signal obtained by subtracting the quantized output signal of the buffers from the input signal by the ON operations of the second switches 160 to the operational amplifier.

The first switches 150 are coupled between the input terminal and the second capacitors 130 and between the second capacitors 130 and the ground terminal, and perform ON-OFF operations at regular intervals. The first switches 150 output the input signal to the second capacitors 130 during the ON operations.

The second switches 160 are coupled between the output terminals of the buffers 140 and the second capacitors 130 and the second capacitors 130 and the operational amplifier 110, and perform ON-OFF operations alternately with the first switches 150. The second switches 160 output the quantized output signals of the buffers 140 to the second capacitors 130.

The operation of the hybrid integrator according to another exemplary embodiment of the present invention will be described below.

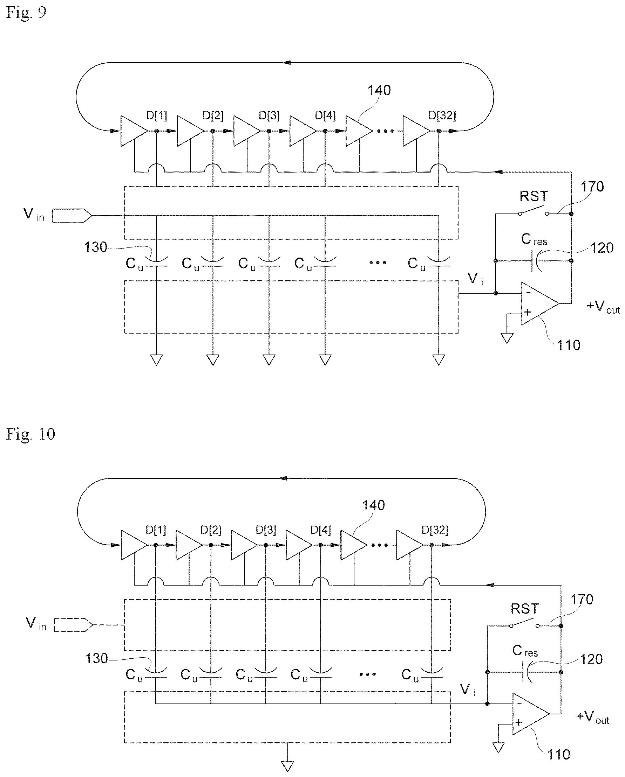

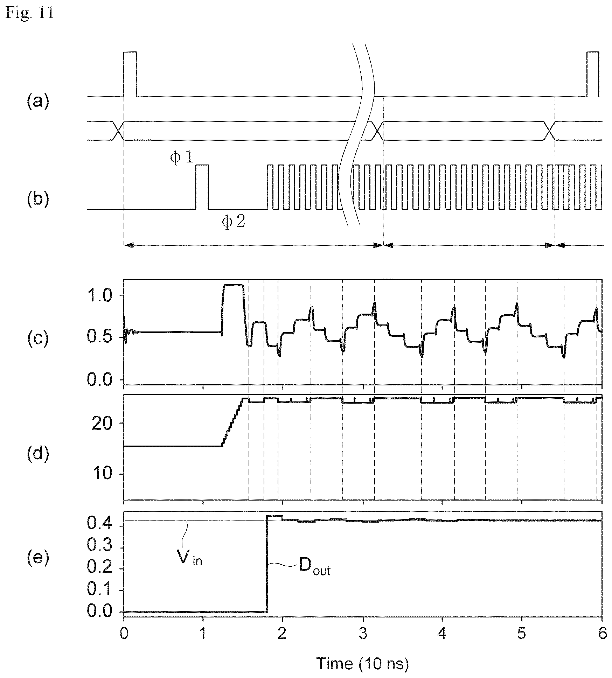

FIG. 9 is a diagram illustrating an operating state of the hybrid integrator according to another exemplary embodiment of the present disclosure by a φ1 signal. FIG. 10 is a diagram illustrating an operating state of the hybrid integrator according to another exemplary embodiment of the present disclosure by a φ2 signal. FIG. 11A is a timing chart illustrating a reset clock that resets the first capacitors. FIG. 11B is a timing chart illustrating a clock signal that controls ON-OFF operations of the first switches and the second switches. FIG. 11C is a timing chart illustrating the output signal of the operational amplifier that is fed back. FIG. 11D is a timing chart illustrating the quantized output signals of the buffers. FIG. 11E is a timing chart illustrating an input signal and a digital output subjected to signal processing, of the hybrid integrator according to another exemplary embodiment of the present disclosure.

Referring to FIG. 11A, the buffers 140 receive the reference voltage Vref by the second reset switch that has received a reset signal, thereby being set to their initial states, and the residual signal in the first capacitor 120 is erased by the first reset switch 170 that has received the reset signal.

Referring to FIGS. 8 and 11B, in the initial state, the buffers 140 include first buffers 141 that receive '1' and output '1', and second buffers 142 that receive '0' and output '0'. In the initial state, the number of first buffers 141 may be the same as the number of second buffers 142.

The buffers 140 include third buffers 143 that receive the state of '0' and output the state of '1', thereby forming rising edges and fourth buffers 144 that receive the state of '1' and output the state of '0', thereby forming falling edges.

For example, when the number of buffers 140 is 32 in order to represent 5 bits, the number of first buffers 141 is 15, and the number of second buffers 142 is 15, and the third buffers 143 are disposed between the first buffers 141 and the second buffers 142, respectively, and the fourth buffers 144 are disposed between the first buffers 141 and the second buffers 142, respectively.

Referring to FIGS. 9 and 11B, by the φ1 signal, the first switches 150 are switched on and the second switches 160 are switched off. At this time, the input signal of the input terminal is stored in the second capacitors 130.

Referring to FIGS. 10 and 11B, by the φ2 signal, the first switches 150 are switched off and the second switches 160 are switched on. Referring to FIG. 10, the buffers 140 output the quantized output signal to the second capacitors 130, and the second capacitors 130 output a difference signal obtained by subtracting the quantized output signal of the buffers 140 from the stored analog input signal, to the operational amplifier 110.

Referring to FIG. 10, the operational amplifier 110 integrates the difference signal, and feeds it back to the buffers 140, and the first capacitor 120 stores the analog residual signal.

Referring to FIG. 6 again, when the output voltage fed from the operational amplifier 110 back to the buffers 140 is greater than the existing voltage, the fourth buffers 144 change to first buffers 141 that receive the state of '1' and output '1', and the second buffers 142 coupled to the fourth buffers 144 change to first buffers 141 through fourth buffers 144 up to the magnitude of the feedback output voltage.

In other words, when the feedback output voltage is greater than the existing voltage, the buffers of the falling edges output '1'. As a result, the number of first buffers 141 increases and fourth buffers 144 that form falling edges are propagated and migrated toward the second buffers 142.

Meanwhile, referring to FIG. 6 again, when the output voltage fed from the operational amplifier 110 back to the buffers 140 is smaller than the existing voltage, the third buffers 143 change to second buffers 142 that receive the state of '0' and output '0', and the first buffers 141 coupled to the third buffers 143 change to second buffers 142 through third buffers 143 up to the magnitude of the feedback output voltage.

In other words, when the feedback output voltage is smaller than the existing voltage, the buffers of the rising edges output '0'. As a result, the number of second buffers 142 increases and third buffers 143 that form rising edges are propagated and migrated toward the first buffers 141.

When this operation is completed, the buffers 140 output the quantized digital signal to the second capacitors 130.

For example, when the input voltage is +10.4, the number of first buffers 141 that output '1' among the buffers 140 is increased to 25 by 10, and the second capacitors 130 coupled to the increased first buffers 141 sample the increase in the number of first buffers 141, i.e., 10 and each store '1'. Thereafter, when the second capacitors 130 output the quantized digital signal of '10' and the operational amplifier 110 outputs 0.4 as the residual signal of the input voltage, the first capacitor 120 stores the analog output signal, i.e., 0.4.

In this state, if an input signal of +3.92 is additional input, in order for the hybrid integrator of the present disclosure to express a total of +14.32, four of the buffers 140 in the state of '0' additionally change to first buffers 141, and fourth buffers 144 are propagated until the total number of first buffers 141 becomes 19. Accordingly, the second capacitors 130 coupled to the increased first buffers 141 sample 4 which is the increase in the number of first buffers 141, and each store '1'. Thereafter, when the second capacitors 130 output a quantized digital signal of '14' and the operational amplifier 110 outputs 0.32 as the residual signal of the input voltage, the first capacitor 120 stores the analog output signal, i.e., 0.32.

Referring to FIG. 11E, it can be seen that a digital output Dout of the hybrid integrator according to another exemplary embodiment of the present disclosure converges to the input voltage Vin from the time point of 20 ns.

The digital output Dout is the final output calculated by averaging output signals D[1] to D[32] obtained by consecutive operations of the hybrid integrator according to the present disclosure.

The above description is merely illustrative of the technical idea of the present disclosure, and those of ordinary skill in the art to which the present disclosure pertains will be capable of various modifications and variations without departing from the essential quality of the present disclosure. Therefore, the exemplary embodiments disclosed in the present disclosure are not intended to limit the technical idea of the present disclosure, but to explain, and the scope of the technical spirit of the present disclosure is not limited by these exemplary embodiments. The scope of protection of the present disclosure should be interpreted by the following claims, and all technical ideas within the scope equivalent thereto should be interpreted as being included in the scope of the present disclosure.

From the foregoing, it will be appreciated that various embodiments of the present disclosure have been described herein for purposes of illustration, and that various modifications may be made without departing from the scope and spirit of the present disclosure. Accordingly, the various embodiments disclosed herein are not intended to be limiting, with the true scope and spirit being indicated by the following claims.

## Claims

1. An analog-digital hybrid integrator circuit comprising:
an operational amplifier coupled to an input terminal;
a first capacitor coupled to the input terminal in parallel with the operational amplifier;
a plurality of second capacitors coupled in parallel with the first capacitor; and
a plurality of buffers that is coupled in series and is coupled in parallel with the plurality of second capacitors, respectively.

2. The hybrid integrator according to claim 1, wherein the operational amplifier provides an output voltage to each of the plurality of buffers.

3. The hybrid integrator according to claim 1, wherein the plurality of buffers is coupled in series so as to form a circular delay chain.

4. The hybrid integrator according to claim 1, wherein the plurality of buffers includes first buffers that receive '1' and output '1', second buffers that receive '0' and output '0', third buffers that receive a state of '0' and output a state of '1', thereby forming rising edges and fourth buffers that receive the state of '1' and output the state of '0', thereby forming falling edges.

5. The hybrid integrator according to claim 4, wherein in an initial state, the number of first buffers is the same as the number of second buffers.

6. The hybrid integrator according to claim 4, wherein when an output voltage fed from the operational amplifier back to the buffers is greater than an existing voltage, the fourth buffers output '1', thereby changing to first buffers, whereby the number of first buffers increases and the fourth buffers that form falling edges are propagated and migrated toward the second buffers.

7. The hybrid integrator according to claim 4, wherein when an output voltage fed from the operational amplifier back to the buffers is smaller than an existing voltage, the third buffers output '0', thereby changing to second buffers, whereby the number of second buffers increases and the third buffers that form rising edges are propagated and migrated toward the first buffers.

8. A hybrid integrator comprising:
an operational amplifier that receives a difference signal obtained by subtracting a quantized output signal from an input signal and integrates the difference signal;
a first capacitor that stores a residual signal;
a plurality of buffers that quantizes an output signal of the operational amplifier and is coupled in series;
a plurality of second capacitors that stores the input signal and the quantized output signal of the buffers;
first switches that are coupled between an input terminal and the plurality of second capacitors and between the plurality of second capacitors and a ground terminal, and are switched so as to output the input signal of the input terminal to the plurality of second capacitors; and
second switches that are coupled between the output terminals of the plurality of buffers and the plurality of second capacitors and between the plurality of second capacitors and the operational amplifier and are switched so as to output the difference signal to the operational amplifier.

9. The hybrid integrator according to claim 8, further comprising:
a first reset switch that is coupled in parallel with the first capacitor and the operational amplifier and resets the residual signal of the first capacitor.

10. The hybrid integrator according to claim 8, further comprising:
a second reset switch that is coupled to the output terminals of the plurality of buffers and receives a reference voltage Vref, thereby resetting the plurality of buffers and the plurality of second capacitors to their initial states when the second reset switch is on.

11. The hybrid integrator according to claim 8, wherein the operational amplifier provides an output voltage to each of the plurality of buffers.

12. The hybrid integrator according to claim 8, wherein the plurality of buffers is coupled in series so as to form a circular delay chain.

13. The hybrid integrator according to claim 8, wherein the plurality of buffers includes first buffers that receive '1' and output '1', second buffers that receive '0' and output '0', third buffers that receive a state of '0' and output a state of'1', thereby forming rising edges and fourth buffers that receive the state of '1' and output the state of '0', thereby forming falling edges.

14. The hybrid integrator according to claim 8, wherein when the first switches are switched on and the second switches are switched off, the input signal of the input terminal is stored in the plurality of second capacitors.

15. The hybrid integrator according to claim 8, wherein when the first switches are switched off and the second switches are switched on, the plurality of buffers outputs a quantized output signal to the plurality of second capacitors, and the plurality of second capacitors outputs a difference signal obtained by subtracting the quantized output signal of the plurality of buffers from the stored analog input signal, to the operational amplifier.
